# EUROPEAN PATENT SPECIFICATION

(11) **EP 2 909 641 B1**
(45) Date of publication and mention of the grant of the patent: **24.06.2020**
(21) Application number: 13783839.7
(22) Date of filing: 17.10.2013
(51) Int. Cl.: G01R 15/14, H01H 33/02, G01R 15/04, G01R 15/18

(54) **CURRENT AND/OR VOLTAGE SENSING DEVICE FOR INTEGRATIVE USE**
STROM- UND/ODER SPANNUNGSERFASSUNGSVORRICHTUNG ZUR INTEGRATIVEN VERWENDUNG
DISPOSITIF DE DÉTECTION DE COURANT ET/OU DE TENSION POUR UTILISATION INTÉGRANTE

(30) Priority: 18.10.2012 EP 12007202
(43) Date of publication of application: 26.08.2015
(73) Proprietor: ABB Schweiz AG, 5400 Baden (CH)
(72) Inventor: JAVORA, Radek, 664 62 Hrusovany u Brna (CZ); SEVCIK, Bretislav, 628 00 Brno (CZ); PODZEMNY, Jaromir, 621 00 Brno (CZ)
(74) Representative: Maiwald Patent- und Rechtsanwaltsgesellschaft mbH
(86) International application number: PCT/EP2013/003127
(87) International publication number: WO 2014/060106

(56) References cited:
- EP-A1- 2 136 216
- EP-A2- 0 933 639
- WO-A1-02/097455
- CZ-U1- 23 097
- DE-A1- 3 313 192
- DE-A1- 3 412 324
- US-A- 1 657 249
- US-A1- 2003 112 569

## Description

Current and/or voltage sensing device for integrative use in electric energy distribution systems, with a current sensor and/or an voltage sensor, according to claim 1.

Current and voltage measurement in medium voltage (MV) switchgears operating in secondary distribution is usually included during production of such switchgears. Switchgear design needs to be done in such a way, that enables location and placement of current and/or voltage transformers inside of said switchgear. Size and weight of these instrument transformers is usually something, that drives the placement and location of other devices that are also within that switchgear.

Low-power stand-alone sensing devices or Electronic instrument transformers are also being used in factory-build switchgears and they achieve much smaller size and weight comparing to conventional instrument transformers or sensing devices.

In case when one wants to add current and/or voltage sensing devices into each phase of existing switchgear, it might be impossible to do that due to limited space between incomming or outgoing cable connection and circuit breaker, switch or disconnector. This is especially valid for conventional instrument transformers using iron core, which occupy significant space that might not be available in existing switchgear without some modification of its design. If switchgear design is significantly modified, new testing might be required in order to assure propper dielectric and/or temperature and/or current withstand or achieve required safety, accuracy and EMC performance.

EP2136216A1 describes a combined measurement device for measuring current and/or voltage of an electrical conductor, comprising a supporting body, a current sensor housed inside the supporting body, and a voltage sensor located at least partially inside the supporting body. A shielding is positioned around the current sensor. The current sensor and the voltage sensor are mutually arranged so as the shielding shields at least partially both the current sensor and the voltage sensor against external electric field disturbances.

DE3412324 describes a gas-insulated medium-voltage switching installation, which is encapsulated in a gas-tight manner by means of tubular mouldings which are joined to one another and attached closure parts. This has a closure part which is adjacent to the free end of a tubular moulding on the current output side and is constructed as a moulding in one or more parts having at least one current conductor element which passes through the moulding and is held in a rigid, pressure-tight and insulated manner. This current conductor element contains connecting contact points both on its end pointing into the inside of the encapsulation and on its opposite end, which is passed out to the external atmosphere, which connecting contact points are in the form of contact sockets or contact pins, and said current conductor element is otherwise surrounded by a current transformer. For a closure part of such a design it is proposed that the end of the current conductor element on the current output side and pointing towards the external atmosphere be allowed to open into at least two connecting contact points. For this purpose, the closure part which is adjacent to the tubular moulding can be provided with a strip-like formed attachment, which runs approximately transversely or at right angles with respect to the longitudinal axis of the moulding and in which the connecting contact points which are connected to the current conductor element are placed side-by-side, in the direction of the longitudinal course of the formed attachment.

So the object of the invention is, to realize optimal compactness and low weight, in order to simplify the installation, and to enable retrofit installation. All these advantageous should be resulted in the purpose of especially in medium voltage switchgears.

So this is solved by the invention, that the voltage sensor and/or the current sensor is/are integrated in an insulating housing, which is designed as a toroid body, surrounding a primary conductor in the ready installed position of the sensing device, by which current and/or electrical potential of the primary conductor will be measured. This is compact, weight reduced and the compactness is in such away, that a retrofit installation even in medium voltage switchgears is simply possible.

Therefore in a furthermore advantageous embodiment, the sensing device is used in a medium voltage switchgear housing in such a way, that also in case of retrofit installation, no additional fixation means or constructive changes are need.

Concerning to that purpose, a further embodiment is given by that in use in medium voltage switchgears, the sensing device is placed between the bushing or any other fixed part of the switchgear and the connected cable.

In sense of reaching the desired compactness it is advantageous, that the current sensor is based on a Rogowski coil arrangement, by which the Rogowski coil is arranged in the torid housing around the primary conductor.

A further advantageous embodiment is, that the voltage sensor is a concentric arrangement in the toroid housing in that way, that an inner, that means near to the primary conductor placed first ring band electrode is concentrically surrounded by an outer ring band electrode as a shielding electrode, and that the electrical capacity between both electrodes and between inner electrode and the primary conductor are used for voltage determination.

A first advantageous embodiment concerning the placement of the sensor elements is, that the current sensor and the voltage sensor are implemented both in one common torid sensor housing in that way, that the current sensor coil is arranged beneath the voltage sensor electrodes

A further advantageous alternative to that is, that the current sensor and the voltage sensor are implemented both in one common torid sensor housing in that way, that the current sensor coil is arranged concentric to the voltage sensor electrodes, where current sensor is located in bigger distance from primary conductor then voltage sensor.

Another advantageous alternative is, that the current sensor and the voltage sensor are implemented both in one common toroid sensor housing in that way, that the current sensor coil or its housing or shielding is serving as the inner electrode of voltage sensor and is positioned concentric to the voltage sensor outer electrode, where outer electrode of voltage sensor is located in bigger distance from primary conductor then current sensor. In some cases, the outer electrode of voltage sensor might even not to be used to achieve required measurements.

A further, very important embodiment is, that the insulating housing containing the voltage sensor and/or the current sensor are designed in that way, that the insulating housing is at least partly inserted into the bushing, and that at least the outer surface in the region where it is inserted into the bushing is provided with a creepage enlargement surface structure. This structure is a series of parallel ringformed structures parallel to the long axis, implemented into the insulating housing of the voltage and/or current sensor.

According to that, it is advantageous, that the bushing is formed in the region, where the insulating housing of the voltage and/or current sensor is inserted as a bell-formed shape, into which the insulating housing is inserted into the bushing from the open side of the bell-formed shape of the bushing.

In combination with the aforesaid embodiment, at least the part of the housing of the voltage and/or current sensor which is provided with a creepage enlargement surface structure is completely inserted into the open end of the bell-formed bushing part.

In a final advantageous embodiment, the voltage sensor is a resistive divider, whiches current path is oriented perpendicular to the long axis of the primary conductor.

The invention is shown in the figures and described as follows.
Fig. 1: Small sized combined current/voltage sensing device
Fig. 2: Small sized combined current/voltage sensing device with reduced height
Fig. 3: Small sized combined current/voltage sensing device with optimized construction
Fig. 4: Small sized combined current/voltage sensing device with reduced height
Fig. 5: Small sized combined current/voltage sensing device with resistive voltage divider
Fig. 6: Small sized combined current/voltage sensing device with combined sensing parts
Fig. 7: Possible location of small combined sensing device
Fig. 8: Housing of the voltage and/or current sensor
Fig. 9: voltage and/or current sensor housing inserted into the bushing

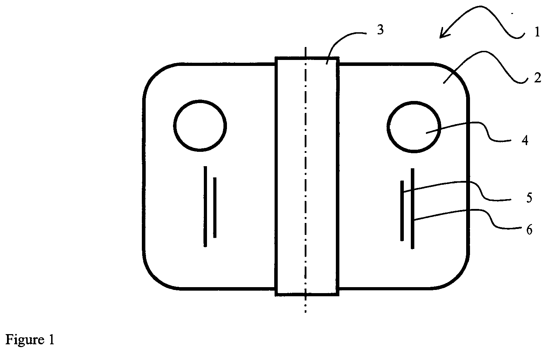

This invention proposes the use of small combined sensing device, that could be used both for factory installations as well as for easy retrofit of existing air-insulated switchgears without the need to significantly modify switchgear design, add additional fixation parts or anyhow interfer into existing construction of the switchgear. Current/voltage sensing device considers the use of current/voltage low-power stand-alone sensing technologies that do not contain any ferromagnetic core, nevertheless, the use of ferromagnetic cores could be also possible, when keeping small size of the elements. Current sensing device, in one preferred embodiment, considers the use of Rogowski coil technology, that enables the use of one single device for the wide range of measured currents and that enables to significantly reduce size of current sensing element. As such current sensing device does not contain any ferromagnetic core, it will be very light-weighted. Voltage sensing device could utilize either capacitive and/or resistive voltage divider technology. This technology also enables significant size and weight reduction, still achieving very good sensing accuracy. As both current and voltage sensing technologies enables creation of very small devices, it is easily possible to combine them into one single device. This possibility is utilized in proposed construction of small sized combined current/voltage sensing device. Such device consists of current and voltage sensing part as shown in Fig. 1.

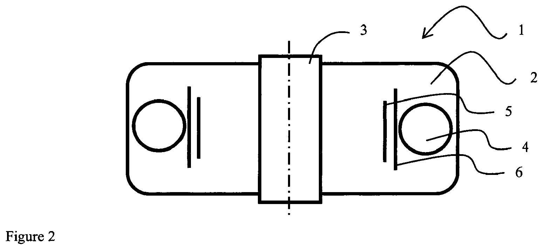

Combined sensing device 1 consists of insulating material 2, that provides sufficient dielectric strength, depending on the voltage level applied on primary conductor 3. Current sensing part 4 senses magnetic field that is proportional to the current flowing through the primary conductor 3. Voltage sensing part consists of primary capacitance created between primary conductor 3 and capacitive electrode 5 and secondary capacitance created between capacitive electrode 5 and shielding electrode 6. Shielding electrode 6 protect capacitive electrode 5 from external electric fields, thus shielding from external disturbances. In case division ratio of capacitances created between primary conductor 3, capacitive electrode 5 and shielding electrode 6 is not sufficient to create required ratio, external capacitors could be electrically connected in parallel to the output of such voltage divider to tune the divider ratio to required level. There might be different configurations of current and voltage sensing parts within the device 1.
Either as shown in Fig. 1, or as shown in Fig. 2.

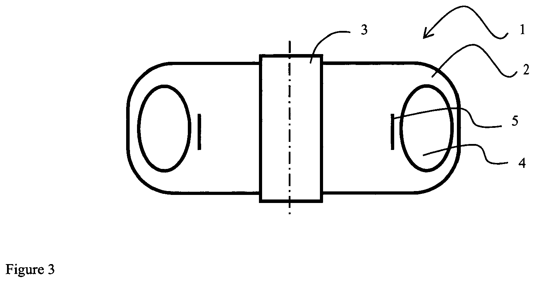

Depending on construction and size of current sensing device, the shielding electrode 6 does not need to be used in case the current sensing part 4 has a shape that is capable of covering the capacitive electrode 5 from size point of view and has its surface at least partly on ground potential. See example of such configuration in Fig. 3.

Due to a very small size that can be achieved, also additional electrode for voltage indication could be included in any of the above described devices.
Small size could be easily achieved by using low-power technologies, but conventional current transformer could be utilized for current measurement as well. In either case, it has to be ensured that dielectric withstand of the insulation material 2 is sufficient to withstand all dielectric tests related to the voltage level where this device is applied.

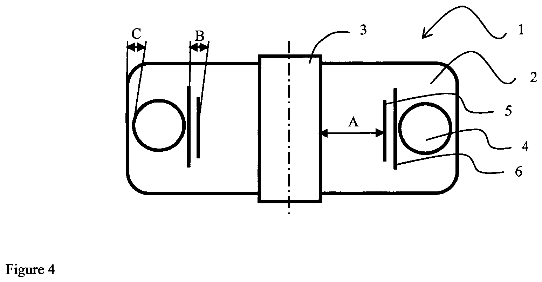

Referring to Fig. 4, it has to be assured that distance A between primary conductor 3 and capacitive electrode is sufficient to withstand required voltage elevels. Distance B between capacitive electrode 5 and shielded electrode 6 is usually very small (1mm is usually sufficient), as the difference of potentials between both electrodes is not huge. Distance C of the current sensing element 4 from the surface of combined device 1 is not required to be more then 0 mm, nevertheless, it is a good practice to have it at least 1mm to properly cover current sensing element from external environment, mechanical damage orfrom high electric stresses depending on surrounding environment or devices.

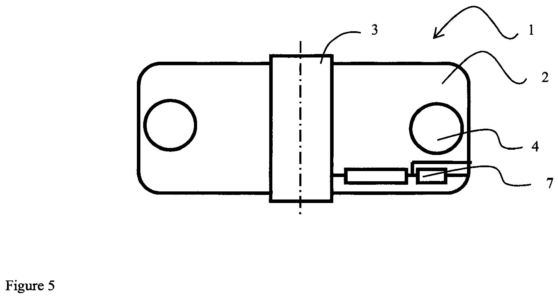

Said combined device 1 can also contain resistive voltage divider instead of capacitive one. In order to achieve a small size required, the resistive divider 7 can be placed e.g. according to Fig. 5.

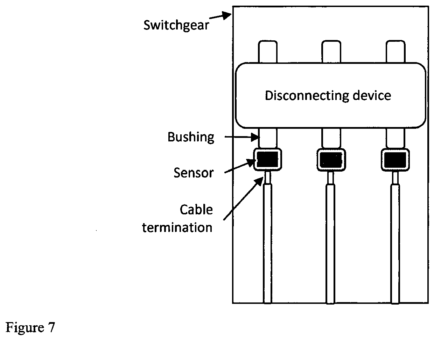

Sensing parts could be combined and/or shared within current and voltage sensing parts. Fig. 7 shows possible construction, where the current sensor is used in the same time also as inner (capacitive) electrode of the voltage sensor. This solution avoid the need for additional electrode, thus reducing costs and complexity of such sensing device. Easiest construction is to use conductive or semi-conductive shielding of current sensor as capacitive electrode.

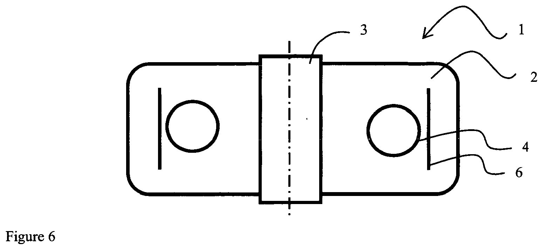

In any of the constructions described in Fig. 1 to Fig.6 above, the outer (shielding) electrode of voltage sensor might not be used, depending on surrounding environment, external influences or sensing accuracy required.

Any of the constructions described in Fig. 1 to Fig. 6 could be applied for air-insulated or gas-insulated switchgears. Any of the constructions described in Fig. 1 to Fig. 6 can have a primary conductor cast in the device 1 or there could be hole inside of the device 1 through which the primary conductor could be inserted.

Biggest advantage of the proposed solution is for applications where incomming or outgoing cables are connected in cable compartment of the air-insulated switchgears. As it is usually possible to move connected cables few centimeters down, the proposed combisensor 1 could be placed between the original connection point on the switchgear and the cable, see possible location shown in Fig. 7.

Due to the light-weight of the combined sensing device, there is no necessity to improve mechanical strength of the connected parts in order to withstand all mechanical forces that might occur during operation or testing of the switchgear.

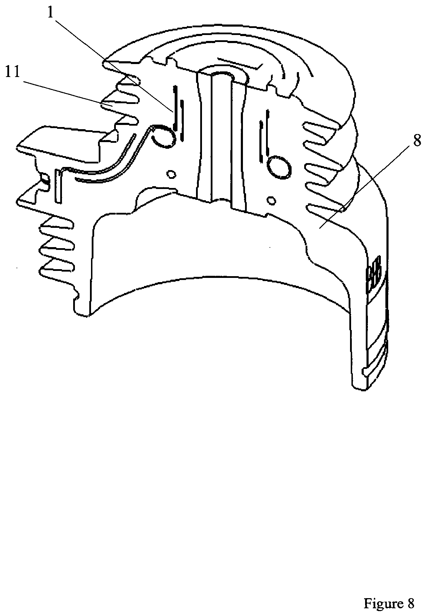

Figure 8 shows the housing of the voltage and/or current sensor, made of an insulating material like epoxy or thermoplastic. Inside the molded structure of the housing, are implemented the sensor elements of the voltage and/or current sensor. Centrally is placed the conductor, which will be connected above with the bushing, and at the bottom with further outgoing conductors.
The housing of the voltage and/or current sensor is provided like shown with serially arranged material integrated ringstructures, in order to enlarge the creepage length. The bottom of the housing of the voltage and/or current sensor is also formed as a bell-shape.

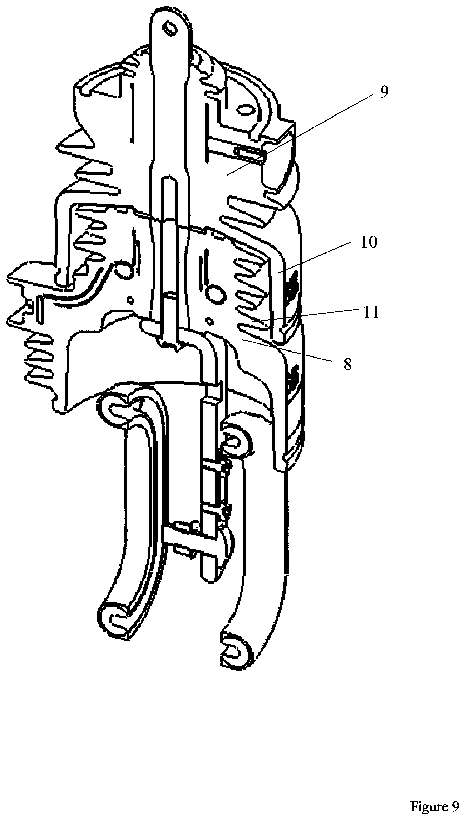

Figure 9 shows the voltage and/or current sensor housing in the ready installed position, wherein in is inserted form the bottom side into the also clock-shaped form of the bushing. It is shown, the conductor of the housing of the voltage and/or current sensor is connected with the conductor of the bushing.
The creepage enlargement structure of the housing of the voltage and/or current sensor is in this ready installed position then perfectly interacting with the clock-shaped inner surface of the bushing in that region. It is also shown, that the electrical connecting points of the sensor is mounted at one side of the insulating housing of the voltage and/or current sensor.

At the bottom side of the housing of the voltage and/or current sensor of figure 9 is shown, that further conductors are fixed as outgoing conductor to externally sided busbars of the switchgear arrangement.

This special embodiment is perfectly adapted to a retrofit requirement.

### Position numbers

- 1: combined sensing device
- 2: insulating material
- 3: primary conductor
- 4: current sensor part
- 5: capacitive electrode
- 6: shielding electrode
- 7: resistive divider

- 8: insulating housing of the voltage and/or current sensor
- 9: bushing
- 10: clockshaped bottom end of the bushing
- 11: creepage enlargement structure

## Claims

1. Current and/or voltage sensing device for integrative use in electric energy distribution systems, with a current sensor and/or an voltage sensor, wherein the voltage sensor and/or the current sensor is/are integrated in an insulating housing, which is designed as at least partly toroid body, surrounding a primary conductor in the ready installed position of the sensing device, by which current and/or electrical potential of the primary conductor will be measured, wherein the insulating housing (8) containing the voltage sensor and/or the current sensor (1) is designed in that way, that the insulating housing is configured to be at least partly inserted into an open bottom side of a bell shaped bushing (9), and wherein an outer surface of the bell shaped bushing in the region where the insulating housing is configured to be at least partly inserted is provided with a creepage enlargement surface structure (11).

2. Current and/or voltage sensing device according to claim 1,
**characterized in**
**that** the current sensor is based on a Rogowski coil arrangement, by which the Rogowski coil is arranged in at least partly toroid housing around the primary conductor.

3. Current and/or voltage sensing device according to one of the aforesaid claims,
**characterized in**
**that** the current sensor is based on a current transformer technology, by which the current transformer is arranged in at least partly toroid housing around the primary conductor.

4. Current and/or voltage sensing device according to one of the aforesaid claims,
**characterized in**
**that** the voltage sensor is a concentric arrangement in at least partly toroid housing in that way, that an inner, that means near to the primary conductor placed first ring band electrode is concentrically surrounded by an outer ring band electrode as a shielding electrode, and that the electrical capacity between both electrodes is used for voltage determination.

5. Current and/or voltage sensing device according to one of the aforesaid claims 1-4
**characterized in**
**that** a current sensor and a voltage sensor are implemented both in one common toroid sensor housing in that way, that the current sensor coil is arranged next to the voltage sensor electrodes.

6. Current and/or voltage sensing device according to one of the aforesaid claims 1-4
**characterized in**
**that** a current sensor and a voltage sensor are implemented both in one common torid sensor housing in that way, that the current sensor coil is arranged concentric to the voltage sensor electrodes.

7. Current and/or voltage sensing device according to one of the aforesaid claims 1-6
**characterized in**
**that** a current sensor or its shielding or its housing is used in the same time also as capacitive electrode of the voltage sensor.

8. Current and/or voltage sensing device according to one of the aforesaid claims 1-5,
**characterized in**
**that** the voltage sensor is a resistive divider, wherein one end is connected to the primary conductor and the other end to the grounding potential.

## Patentansprüche

1. Strom- und/oder Spannungserfassungsvorrichtung zur integrativen Verwendung in elektrischen Energieverteilungssystemen, mit einem Stromsensor und/oder einem Spannungssensor, wobei der Spannungssensor und/oder der Stromsensor in einem isolierenden Gehäuse integriert ist/sind, das als zumindest teilweise toroidförmiger Körper gestaltet ist, der einen Primärleiter in der betriebsbereit installierten Position der Erfassungsvorrichtung umgibt, durch die Strom und/oder elektrisches Potenzial des Primärleiters gemessen wird/werden, wobei das den Spannungssensor und/oder den Stromsensor (1) enthaltende isolierende Gehäuse (8) derart gestaltet ist, dass das isolierende Gehäuse dazu ausgelegt ist, zumindest teilweise in eine offene Unterseite einer glockenförmigen Durchführung (9) eingeführt zu werden, und wobei eine äußere Oberfläche der glockenförmigen Durchführung in der Region, in der das isolierende Gehäuse gemäß Auslegung zumindest teilweise eingeführt werden kann, mit einer Kriechvergrößerungsoberflächenstruktur (11) versehen ist.

2. Strom- und/oder Spannungserfassungsvorrichtung nach Anspruch 1,
**dadurch gekennzeichnet,**
**dass** der Stromsensor auf einer Rogowskispulenanordnung basiert, wobei die Rogowskispule in einem zumindest teilweise toroidförmigen Gehäuse um den Primärleiter herum angeordnet ist.

3. Strom- und/oder Spannungserfassungsvorrichtung nach einem der vorhergehenden Ansprüche,
**dadurch gekennzeichnet,**
**dass** der Stromsensor auf einer Stromtransformatortechnologie basiert, wobei der Stromtransformator in einem zumindest teilweise toroidförmigen Gehäuse um den Primärleiter herum angeordnet ist.

4. Strom- und/oder Spannungserfassungsvorrichtung nach einem der vorhergehenden Ansprüche,
**dadurch gekennzeichnet,**
**dass** es sich bei dem Spannungssensor derart um eine konzentrische Anordnung in einem zumindest teilweise toroidförmigen Gehäuse handelt, dass eine innere, das heißt nahe bei dem Primärleiter angeordnete, erste Ringbandelektrode durch eine äußere Ringbandelektrode als eine Abschirmelektrode konzentrisch umgeben ist, und dass die elektrische Kapazität zwischen beiden Elektroden zur Spannungsbestimmung verwendet wird.

5. Strom- und/oder Spannungserfassungsvorrichtung nach einem der vorhergehenden Ansprüche 1 bis 4,
**dadurch gekennzeichnet,**
**dass** ein Stromsensor und ein Spannungssensor beide derart in einem gemeinsamen toroidförmigen Sensorgehäuse implementiert sind, dass die Stromsensorspule neben den Spannungssensorelektroden angeordnet ist.

6. Strom- und/oder Spannungserfassungsvorrichtung nach einem der vorhergehenden Ansprüche 1 bis 4,
**dadurch gekennzeichnet,**
**dass** ein Stromsensor und ein Spannungssensor beide derart in einem gemeinsamen toroidförmigen Sensorgehäuse implementiert sind, dass die Stromsensorspule konzentrisch zu den Spannungssensorelektroden angeordnet ist.

7. Strom- und/oder Spannungserfassungsvorrichtung nach einem der vorhergehenden Ansprüche 1 bis 6,
**dadurch gekennzeichnet,**
**dass** ein Stromsensor oder dessen Abschirmung oder dessen Gehäuse gleichzeitig auch als kapazitive Elektrode des Spannungssensors verwendet wird.

8. Strom- und/oder Spannungserfassungsvorrichtung nach einem der vorhergehenden Ansprüche 1 bis 5,
**dadurch gekennzeichnet,**
**dass** es sich bei dem Spannungssensor um einen ohmschen Teiler handelt, wobei ein Ende mit dem Primärleiter und das andere Ende mit dem Massepotenzial verbunden ist.

## Revendications

1. Dispositif de détection de courant et/ou de tension pour une utilisation intégrée dans des systèmes de distribution d'énergie électrique, comprenant un détecteur de courant et/ou un détecteur de tension, le détecteur de tension et/ou le détecteur de courant étant intégré(s) dans un boîtier isolant, qui est conçu sous forme de corps au moins partiellement torique entourant un conducteur primaire dans la position déjà installée du dispositif de détection, au moyen duquel le courant et/ou le potentiel électrique du conducteur primaire seront mesurés, le boîtier isolant (8) contenant le détecteur de tension et/ou le détecteur de courant (1) étant conçu de telle façon que le boîtier isolant soit configuré pour être au moins partiellement inséré dans un côté inférieur ouvert d'une traversée en forme de cloche (9), dans lequel dispositif une surface extérieure de la traversée en forme de cloche, dans la région dans laquelle le boîtier isolant est configuré pour être au moins partiellement inséré, est dotée d'une structure de surface d'agrandissement de ligne de fuite (11).

2. Dispositif de détection de courant et/ou de tension selon la revendication 1,
**caractérisé**
**en ce que** le détecteur de courant repose sur un agencement de bobine de Rogowski, dans lequel la bobine de Rogowski est agencée dans un boîtier au moins partiellement torique autour du conducteur primaire.

3. Dispositif de détection de courant et/ou de tension selon l'une des revendications précédentes,
**caractérisé**
**en ce que** le détecteur de courant repose sur une technologie de transformateur de courant, dans laquelle le transformateur de courant est agencé dans un boîtier au moins partiellement torique autour du conducteur primaire.

4. Dispositif de détection de courant et/ou de tension selon l'une des revendications précédentes,
**caractérisé**
**en ce que** le détecteur de tension repose sur un agencement concentrique dans un boîtier au moins partiellement torique de telle façon qu'une première électrode en bracelet intérieure, c'est-à-dire placée à proximité du conducteur primaire, soit entourée de manière concentrique par une électrode en bracelet extérieure servant d'électrode de blindage, et **en ce que** la capacité électrique entre les deux électrodes soit utilisée pour la détermination de tension.

5. Dispositif de détection de courant et/ou de tension selon l'une des revendications 1 à 4 précédentes,
**caractérisé**
**en ce qu'**un détecteur de courant et un détecteur de tension sont tous deux mis en œuvre dans un boîtier de détecteurs torique commun de telle façon que la bobine de détecteur de courant soit agencée à proximité des électrodes de détecteur de tension.

6. Dispositif de détection de courant et/ou de tension selon l'une des revendications 1 à 4 précédentes,
**caractérisé**
**en ce qu'**un détecteur de courant et un détecteur de tension sont tous deux mis en œuvre dans un boîtier de détecteurs torique commun de telle façon que la bobine de détecteur de courant soit agencée de manière concentrique par rapport aux électrodes de détecteur de tension.

7. Dispositif de détection de courant et/ou de tension selon l'une des revendications 1 à 6 précédentes,
**caractérisé**
**en ce qu'**un détecteur de courant ou son blindage ou son boîtier soit utilisé en même temps comme électrode capacitive du détecteur de tension.

8. Dispositif de détection de courant et/ou de tension selon l'une des revendications 1 à 5 précédentes,
**caractérisé**
**en ce que** le détecteur de tension est un diviseur résistif, dont une extrémité est reliée au conducteur primaire et l'autre extrémité au potentiel de mise à la terre.
